# EUROPEAN PATENT APPLICATION

(11) **EP 1 265 271 A1**
(43) Date of publication of application: **11.12.2002**
(21) Application number: 01999963.0
(22) Date of filing: 05.12.2001
(51) Int. Cl.: H01L 21/027, G03F 7/20

(54) **X-RAY PROJECTION EXPOSURE DEVICE, X-RAY PROJECTION EXPOSURE METHOD, AND SEMICONDUCTOR DEVICE**

(30) Priority: 06.12.2000 JP 2000371052
(71) Applicant: Nikon Corporation, Tokyo 100-8831 (JP)
(72) Inventor: OSHINO, Tetsuya, Chiyoda-ku, Tokyo 100-8331 (JP)
(74) Representative: Viering, Jentschura & Partner
(86) International application number: PCT/JP01/10615
(87) International publication number: WO 02/047132

(57) **Abstract**

An X-ray projection exposure apparatus capable of overlaying a desirable very fine pattern on a circuit pattern formed on a wafer in high precision to expose the very fine pattern is provided. This X-ray projection exposure apparatus is comprised of: an X-ray source; an X-ray illuminating optical system for irradiating X-rays generated from the X-ray source onto a mask having a certain pattern; a mask stage for holding the mask; an X-ray projecting optical system 1 for receiving X-rays derived from the mask to project an image of the pattern onto a wafer on which a resist has been coated; a wafer stage 5 for holding the wafer 4; and a mark position detecting system 6 for detecting a position of a mark 4a which is formed on the wafer 4. Note that a center 36 of an exposure image field of the X-ray projecting optical system 1 is located at a position separated from a center axis 1a of this X-ray projecting optical system 1. Also, a center axis 6a of a mark position detecting system 6 is located on the side of the exposure image field with respect to a center axis 1a of the X-ray projecting optical system 1.

## Description

### TECHNICAL FIELD

The present invention relates to an X-ray projection exposure apparatus for transferring, for instance, circuit patterns formed on a photomask (either mask or reticle) onto a substrate such as a wafer via a reflection type imaging optical system by employing X-rays having wavelengths of 1 to 30 nm. Also, the present invention is directed to both an exposure method using the above-described X-ray projection exposure apparatus, and also a semiconductor device manufactured by this X-ray projection exposure apparatus.

### BACKGROUND ART

Exposure apparatus used to manufacture semiconductor devices, which have been employed in industrial fields, project and transfer circuit patterns formed on photomask (will be referred to as "mask" hereinafter) planes as object planes via projecting optical systems onto substrates such as wafers. Both a mask and a focusing element (lens etc.) of the projecting optical system commonly correspond to a transmission system. As an exposure light source, for example, i-lines of a high-pressure mercury lamp, a KrF laser light source, and the like may be utilized.

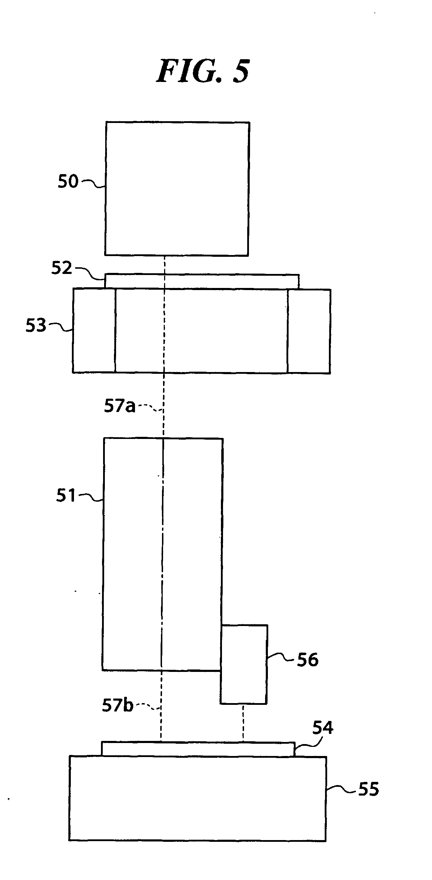

Fig. 5 is a conceptional diagram for showing an exposure apparatus of an optical transmission system.

This exposure apparatus is constructed by a light source (not shown), an illuminating optical system 50, a projecting optical system 51, a mask stage 53 for holding a mask 52, a wafer stage 55 for holding a wafer 54, a wafer mark position detecting system 56, a mask mark position detecting system (not shown), and the like.

A surface position detecting system of a wafer, and the like are also provided in addition to the above-described elements. In this surface position detecting system, for instance, light beams are obliquely illuminated onto a wafer, and reflection light beams thereof are detected by a photodetector. A surface position of the above-described wafer along the optical axis direction may be grasped by this surface position detecting system. A concrete example of such a surface position detecting system is disclosed in Japanese Laid-open Patent Application No. Hei-6-283403, Japanese Laid-open Patent Application No. Hei-8-64506, and Japanese Laid-open'Patent Application No. Hei-10-214783.

The above-described mark position detecting system may detect a position of a mark formed on the wafer and a position of a mark formed on the mask by way of an optical means.

A pattern has been formed on the mask 52, while this pattern is made in an equi-magnification, or in an enlarge magnification with respect to such a pattern to be transferred to the wafer 54.

The projecting optical system 51 is normally constituted by a plurality of lenses and the like. The projecting optical system 51 may form an image of the pattern formed on the mask 52 onto the above-described wafer 54 and may transfer these patterns to this wafer 54 at once. Since this projecting optical system 51 owns such an exposure field having a square of approximately 20 mm, a desirable area (for example, area used for 2 semiconductor chips) can be exposed at once.

Since a circuit of a semiconductor device is formed over a plurality of layers, in the case that the semiconductor device is manufactured by way of a lithography method with employment of a projection exposure apparatus, an overlay exposing operation is carried out in high accuracy on such a circuit which has already been formed on a wafer. To secure overlay accuracy, a mechanism capable of detecting both a position of the mask 52 and a position of the wafer 54 during exposure operation is required. As such a detecting system, both an interferometer (not shown) and the mark position detecting system 56 (mark detecting system provided on mask side is not shown) are employed, while the interferometer measures the position of the mask stage 53 and the position of the wafer stage 55 in real time, and the mark position detecting system 56 detects marks (not shown) formed on both the wafer 54 and the mask 52 by way of an optical means.

While the mark position detecting system 56 is constructed as, for example, an optical microscope, an enlarged image of a mark is detected by an image detector such as a CCD. There are many examples that a mark position detecting system is arranged adjacent to the projecting optical system 51 due to restrictions of appliance arrangements. A concrete example of such a mark position detecting system is disclosed in Japanese Laid-open Patent Application No. Hei-5-21314, and so on.

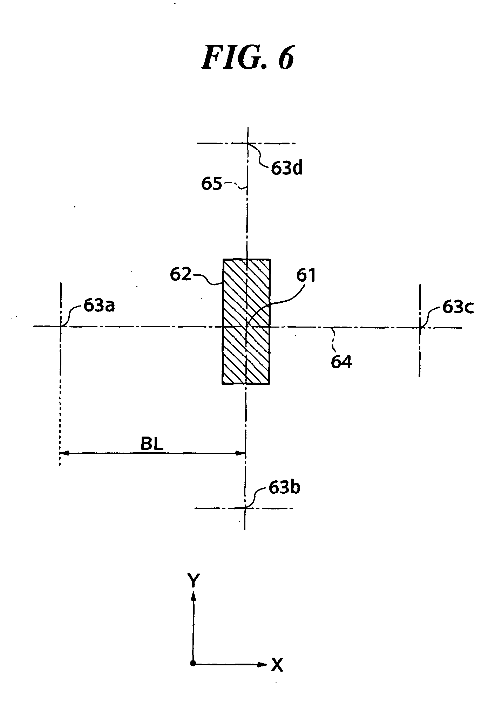

Fig. 6 is an explanatory diagram for indicating a relationship between an exposure image field on an exposure plane and a detection center of a mark position detecting system.

A hatched area of a center portion in Fig. 6 corresponds to an exposure image field 62, the center of which is an exposure image field center 61. In this example, the exposure image field 62 is a rectangular shape. A straight line indicated by a dot-dash line corresponds to a center line 64 along an x direction, while this straight line passes through the exposure image field center 61 and is extended along a transverse direction which is located in parallel to a drive axis of a wafer stage. A straight line which is intersected at a right angle at the exposure image field center 61 with respect to this x-direction center line 64 corresponds to a center line 65 along a y direction.

In a conventional general exposure apparatus, a center axis of a projecting optical system is coincident with the center point 61 of the exposure image field 62 having either the square shape or the rectangular shape. This reason is given as follows: The lenses of the transmission refractive system of the projecting optical system are arranged in the axial symmetrical shape, and optical aberration of the center portion is small. As a result, the image field located near this axis may be employed in principle.

Next, a detection center 63 will now be explained. In the case that an optical detecting system is employed as the mark position detecting system 56 (see Fig. 5), the detection center 63 is arranged at a position separated from the center point 61 of the above-described exposure image field by a certain distance ("BL" shown in this drawing) in order that the mark position detecting system 56 does not interfere with the projecting optical system 51'. It should be noted that the detection center 63 is essentially equal to a cross point between the center axis of the optical system of the mark position detecting system 56 and the wafer plane. Also, the distance "BL" is nearly equal to a dimension defined by adding a radius of a lens-barrel of the projecting optical system 51 to a radius of an optical lens-barrel of the mark position detecting system 56. Furthermore, assuming now that a direction coincident with the drive axis of the wafer stage is defined as the x-direction center line 64 shown in Fig. 6, and also, another direction perpendicular to the above-described direction is defined as the y-direction center line 65, the detection center 63 is generally arranged at any point of four positions 63a, 63b, 63c, and 63d, which are located on these lines (on either x axis or y axis) by the distance "BL" separated from the center point 61 of the projecting optical system.

When an exposing operation is carried out, a distance "BL" (this distance is referred to as "base line") between the center 61 of the exposure image field and the detection center 63 of the mark position detecting system is previously measured. Then, while a mark position on the wafer is detected by the mark position detecting system, a coordinate value of a position on a wafer which is wanted to be exposed is acquired based upon the base line and a relationship between the previously-defined mark position and the position on the wafer which is wished to be exposed. The wafer stage is transported in such a manner that the position of this coordinate position can be made coincident with the center position of the exposure image field.

The exposure image field is located at the desirable position on the wafer in accordance with the above-described method, so that the pattern could be transferred to this desirable position so as to be formed thereon.

On the other hand, recently, while semiconductor circuits are manufactured in higher integration and having higher performance, resolution of exposure apparatus is required to be further higher. In general, a resolving power "W" of an exposure apparatus may be mainly determined based upon both an exposing wavelength "λ" and a numerical aperture "NA" of an imaging optical system, and may be expressed by the following formula:$\text{W = k1λ/NA,}$ where symbol "k1" indicates a constant.

As a result, in order to improve the resolving power, the wavelength of the exposing light should be shortened, or the numerical aperture should be increased. As previously explained, in the exposure light source of the exposure apparatus which is presently employed to manufacture semiconductors, the "i"-line having the wavelength of 365 nm is mainly used, and the resolving power of 0.5 µm is obtained under the numerical aperture of approximately 0.5. Since it is difficult to furthermore increase the numerical aperture due to optical designing aspects, there is a demand. to shorten the wavelength of the exposing light.

To this end, as exposing light having a wavelength shorter than that of the i-line, for example, an excimer laser is very recently utilized. Since a wavelength of a KrF excimer laser is 248 nm and also a wavelength of an ArF excimer laser is 193 nm, a resolving power of using the KrF excimer laser could be obtained as 0.25 µm, whereas a resolving power of using the ArF excimer laser could be obtained as 0.18 µm.

Then, when an X-ray having a wavelength shorter than that of the excimer laser is utilized as the exposing light, for instance, when the wavelength of the X-ray is selected to be 13 nm, a resolving power smaller than, or equal to 0.1 µm may be obtained.

In the case of such an X-ray projection exposure apparatus, since a lens material having a superior transmission characteristic of X-rays cannot be manufactured in industrial fields, all of projection focusing optical systems should be constituted by reflection mirrors. In the case of a reflection type optical system, it is difficult to design an optical system having a wide image field in the vicinity of a center axis of the reflection type optical system. On the other hand, while an exposure image field of a projecting optical system is formed at a position separated from a center axis of an optical system (so-called "out-of-center axis optical system"), when the exposure image field is formed in, e.g., a ring shape, high resolution can be obtained in an elongated exposure image field.

Furthermore, when an exposing operation is carried out, since both a mask and a wafer are scanned, a semiconductor chip having a square dimension of 20 mm, or more can be exposed in an imaging optical system with a small image field. In accordance with an X-ray projection exposure apparatus using this method, a desirable exposure area can be secured.

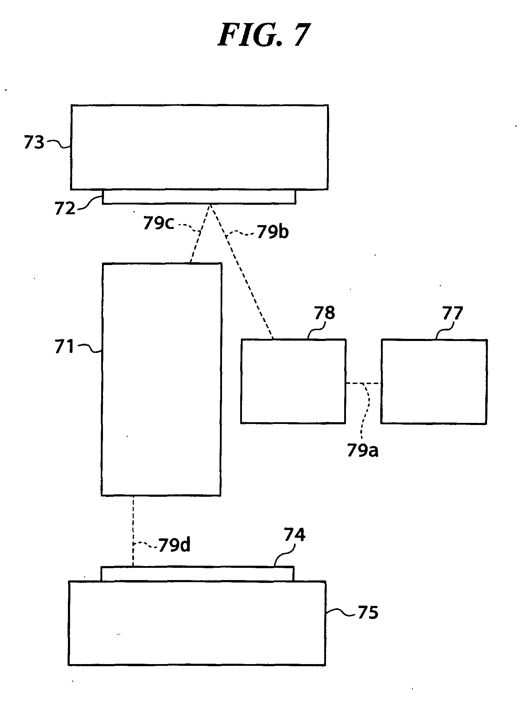

Fig. 7 is a conceptional view of a presently conceivable X-ray projection exposure apparatus.

A major structural element of the X-ray projection exposure apparatus is mainly made of an X-ray light source 77, an X-ray illuminating optical system 78, an X-ray projecting optical system 71, a mask 72, a mask stage 73, a wafer 74, and a wafer stage 75.

The X-ray light source 77 corresponds to, for example, a discharge plasma type X-ray light source. The illuminating optical system 78 is arranged by several stages of reflection lenses, filters and the like. This illuminating optical system 78 irradiates ring-shaped illumination light toward the mask 72.

The X-ray projecting optical system 71 is constituted by a plurality of reflection mirrors and the like, and forms an image of the pattern prepared on the mask 72 onto the wafer 74. A multi-layer film is provided on a surface of each of the reflection mirrors in order to raise reflectance of X-rays. The X-ray projecting optical system 71 owns a ring-shaped exposure image field, and transfers a pattern of a ring-shaped area of a portion of the mask 72 to the surface of the wafer 74.

The mask 72 is a reflection type mask, and a circuit pattern is formed on a reflection surface of this reflection type mask. Since the mask is the reflection type mask, the X-ray projecting optical system 71 constitutes a non-telecentric optical system on the side of this mask.

Since absorptions of X-rays having wavelengths of 1 to 30 nm with respect to an atmosphere are large, at least X-ray optical paths of an X-ray exposure apparatus are preferably maintained under air-subtracted atmosphere, He atmosphere, or vacuum environment. In the most preferable case, the X-ray optical paths of the X-ray exposure apparatus are maintained under vacuum environment. To this end, the optical system of the X-ray projection exposure apparatus is arranged with a vacuum chamber (not shown).

In a semiconductor device, since a circuit is formed over a plurality of layers, when a pattern of a semiconductor device is also transferred and exposed by an x-ray projection exposure apparatus, the subsequent circuit pattern is exposed and overlayed on the circuit which has already been formed on a wafer. In order to execute this overlay-exposure operation in high accuracy, it is required to employ a system capable of precisely detecting a position of the mask 72 and a position of the wafer 74 while the exposing operation is carried out. As such a system, both an interferometer (not shown) and a mark position detecting system (not shown) are used. The interferometer measures a position of the mask stage 73 and a position of the wafer stage 75 in real time. The mark position detecting system detects marks (not shown) formed on both the wafer 74 and the mask 72 by way of an optical means, which are used so as to acquire reference positions of both the above-explained stages.

On the other hand, in the case that a pattern of a semiconductor device is transferred, an image of the pattern is required to be projected onto a desirable position on a wafer. The positional precision of this image must be made narrower than at least a minimum line width of a pattern to be formed. Preferably, this positional precision of this image may be made narrower than, or equal to 1/4 of the minimum line width of the pattern. As a consequence, in connection with an improvement in resolving powers of exposure apparatus, positional precision of patterns, namely overlay accuracy must also be improved.

Since the minimum line width of the projection pattern of the x-ray projection exposure apparatus is narrower than that of the conventional optical projection exposure apparatus, the overlay accuracy must also be improved. In order to improve the overlay accuracy, the detecting precision of the alignment mark is also required to be improved, the driving accuracy of the wafer stage is required to be improved, and a stability of the base line is required to be improved. The stability of the base line implies such a degree at which this value is kept constant during a time period defined after the base line (namely, interval between exposure image field center and mark position detecting system, i.e., BL of Fig. 6) has been measured, until the exposure operation is carried out. If this base line stability becomes unstable, then the exposing position cannot be aligned at the desirable position of the wafer, but this causes the overlay error. The factor where the base line is varied is caused by deformations of the lens-barrel of the projecting optical system, and deformations of the supporting mechanism for supporting this lens-barrel. As a consequence, the stability of the base line may be influenced by the stability of the lens-barrel, the stability of the mark position detecting system, the stabilities of the supporting mechanisms for supporting these lens-barrel and mark position detecting system, and also the length of the base line. In such a case that the mark position is detected, the position and the orientation of the wafer is aligned, and thereafter, the process operation is advanced to the exposing operation, the wafer stage is driven from the detection position of the mark position detecting system up to the exposing position. Accordingly, if the base line becomes long, i.e., the distance between the detection position of the mark position detecting system and the exposure image field is made long, then the drive distance of the wafer stage becomes long, so that the positional precision of the stage is also deteriorated and the overlay accuracy is deteriorated.

As to the presently proposed x-ray projection exposure apparatus, it is practically difficult to secure a sufficiently high base line stability. As a result, an occurrence of such a problem may be predicted. That is, the overlay accuracy corresponding to the resolving power cannot be obtained. Thus, there is a risk that a yield of semiconductor devices to be manufactured cannot be guaranteed.

The present invention has been made to solve the above-described problems, and has an object to provide an x-ray projection exposure apparatus capable of overlaying a desirable very fine pattern on a circuit pattern formed on a wafer in high precision so as to expose the very fine pattern.

### DISCLOSURE OF THE INVENTION

As a first aspect, the present invention is to provide such an X-ray projection exposure apparatus (Claim 1) comprising: an X-ray source; an X-ray illuminating optical system for irradiating X-rays generated from the X-ray source onto a mask having a certain pattern; a mask stage for holding the mask; an X-ray projecting optical system for receiving X-rays derived from the mask to project an image of the pattern onto a wafer on which a resist has been coated; a wafer stage for holding the wafer; and a mark position detecting system for detecting a position of a mark which is formed on either the wafer or the wafer stage; wherein: an exposure image field of the X-ray projecting optical system is located at a position separated from a center axis of the X-ray projecting optical system; and a detection center of the mark position detecting system is located on the side of the exposure image field with respect to the center axis of the X-ray projecting optical system.

Also, as a second aspect, the present invention is to provide such an X-ray projection exposure apparatus (Claim 2) comprising: an X-ray source; an X-ray illuminating optical system for irradiating X-rays generated from the X-ray source onto a mask having a certain pattern; a mask stage for holding the mask; an X-ray projecting optical system for receiving X-rays derived from the mask to project an image of the pattern onto a wafer on which a resist has been coated; a wafer stage for holding the wafer; and a mark position detecting system for detecting a position of a mark which is formed on either the wafer or the wafer stage; wherein: an exposure image field of the X-ray projecting optical system is located at a position separated from a center axis of the X-ray projecting optical system; and in such a case that while a cross point between the center axis of the X-ray projecting optical system and an image plane of the X-ray projecting optical system is set as an origin on the image plane of the X-ray projecting optical system, an x-y coordinate system is defined in such a manner that a center of the exposure image field is located at a position of x < 0 on an x axis, a detection center of the mark position detecting system is located within an area of x ≤ 0.

Also, as a third aspect, the present invention is to provide such an X-ray projection exposure apparatus (Claim 3) as claimed in claim 2, wherein: the detection center is arranged either on the x axis or on a straight line which passes through the center of the exposure image field of the X-ray projecting optical system and is intersected with the x axis at a right angle.

Also, as a fourth aspect, 'the present invention is to provide such an X-ray projection exposure apparatus (Claim 4) as claimed in claim 1, or claim 2 wherein: the mark position detecting system irradiates visible light, infrared light, or ultraviolet light onto the mark, and detects reflection light, scattering light, or diffraction light of the visible light, the infrared light, or the ultraviolet light.

Also, as a fifth aspect, the present invention is to provide such an X-ray projection exposure apparatus (Claim 5) as claimed in claim 1, or claim 2 wherein: the mark position detecting system is arranged by an optical system, and the optical system owns a function for correcting a change in focal positions, which is caused by a refractive index change of a medium of an optical path.

Also, as a sixth aspect, the present invention is to provide such an X-ray projection exposure method wherein: X-rays generated from an X-ray source are irradiated onto a mask having a certain pattern; the mask is held by a mask stage; an image of a pattern of the mask is projected onto a wafer on which a resist has been coated; the wafer is held by a wafer stage; a position of a mark formed on either the wafer or the wafer stage is detected by employing a mark position detecting system; an exposure image field of the X-ray projecting optical system is located at a position separated from a center axis of the X-ray projecting optical system; in such a case that while a cross point between the center axis of the X-ray projecting optical system and an image plane of the X-ray projecting optical system is set as an origin on the image plane of the X-ray projecting optical system, an x-y coordinate system is defined in such a manner that a center of the exposure image field is located at a position of x < 0 on an x axis, a detection center of the mark position detecting system is arranged within an area of x ≤ 0; and the wafer stage is driven in response to a detection signal of the mark position detecting system so as to form a projection image of a circuit pattern formed on the mask at a desirable position of the wafer.

Also, as a seventh aspect, the present invention is to provide such an X-ray projection exposure method (Claim 7) as claimed in claim 6 wherein: a distance between the origin of the x-y coordinate system and the center of the exposure image field of the x-ray projecting optical system is measured, and a drive amount of the wafer stage is determined based upon a measurement value of the distance.

Also, as an eight aspect, the present invention is to provide such a semiconductor device (Claim 8) wherein: the semiconductor device is manufactured by executing an exposing operation in accordance with the X-ray projection exposure method as recited in claim 6, or claim 7.

### BRIEF DESCRIPTION OF THE DRAWINGS

Fig. 1 is a schematic diagram of an x-ray projection exposure apparatus according to the present invention.
Fig. 2 is a diagram for indicating a concrete structural example of a mark position detecting system.
Fig. 3 is a diagram for indicating a positional relationship between an exposure image field and a detection center of the mark position detecting system of the x-ray projection exposure apparatus according to the present invention.
Fig. 4 is a schematic diagram of an x-ray projection exposure apparatus according to the present invention.
Fig. 5 is a conceptional diagram for showing an exposure apparatus of an optical transmission system.
Fig. 6 is an explanatory diagram for indicating a relationship between the exposure image field and the detection center of the mark position detecting system of the conventional exposure apparatus.
Fig. 7 is a conceptional diagram for indicating the presently conceivable x-ray projection exposure apparatus.

### BEST MODE FOR CARRYING OUT THE INVENTION

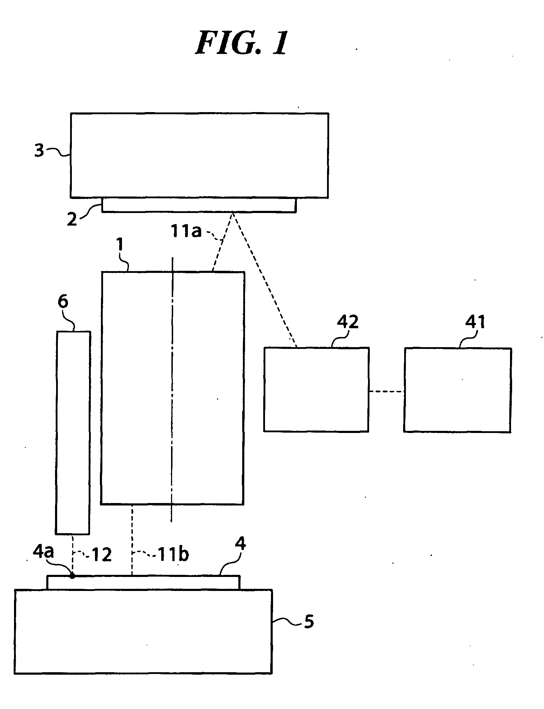

Fig. 1 is a schematic diagram for indicating an x-ray projection exposure apparatus according to the present invention.

A major constructional element of the x-ray projection exposure apparatus according to the present invention is an x-ray source 41, an x-ray illuminating optical system 42, an x-ray projecting optical system 1, a mask stage 3 for holding a mask 2, a wafer stage 5 for holding a wafer 4, a wafer mark position detecting system 6, and a mask mark position detecting system (not shown).

The x-ray source 41 corresponds to, for example, a discharge plasma type x-ray light source. The x-ray illuminating optical system 42 is arranged by several stages of lenses, filters and the like. This x-ray illuminating optical system 42 irradiates ring-shaped illumination light toward the mask 2. The mask 2 is a reflection type mask, and a pattern is formed on a reflection surface of this mask 2, while this pattern is made in an equi-magnification; or in an enlarge magnification with respect to such a pattern to be transferred to the wafer 4. The x-ray projecting optical system 1 owns a ring-shaped exposure image field, and is constituted by a plurality of reflection mirrors, and the like. Since the mask 2 is the reflection type mask, the x-ray projecting optical system 1 constitutes a non-telecentric optical system on. the side of this mask. The pattern of the mask 2 is focused on a surface of the wafer 4 by the x-ray projecting optical system 1. At this time, while both the mask 2 and the wafer 4 are synchronous-scanned at a constant speed, a pattern area of the mask 2 is selectively exposed so as to be transferred to the surface of the wafer 4.

It should be understood that since absorptions of x-rays having wavelengths of 1 to 30 nm with respect to an atmosphere are large, at least x-ray optical paths of an x-ray exposure apparatus are preferably maintained under air-subtracted atmosphere, He atmosphere, or vacuum environment. In the most preferable case, the x-ray optical paths of the x-ray exposure apparatus are maintained under vacuum environment. To this end, the optical system of the x-ray projection exposure apparatus is arranged with a vacuum chamber (not shown).

The above-described wafer mark position detecting system corresponds to such an apparatus for detecting, for example, both a position of a mark (not shown) on a wafer stage, and a position of a mark 4a on the wafer by employing an optical means, and the like. Based upon the positional information of the wafer obtained from this position detecting system, a wafer coordinate is set to drive the wafer stage, and then, the pattern on the mask is exposed onto a desirable position on the wafer.

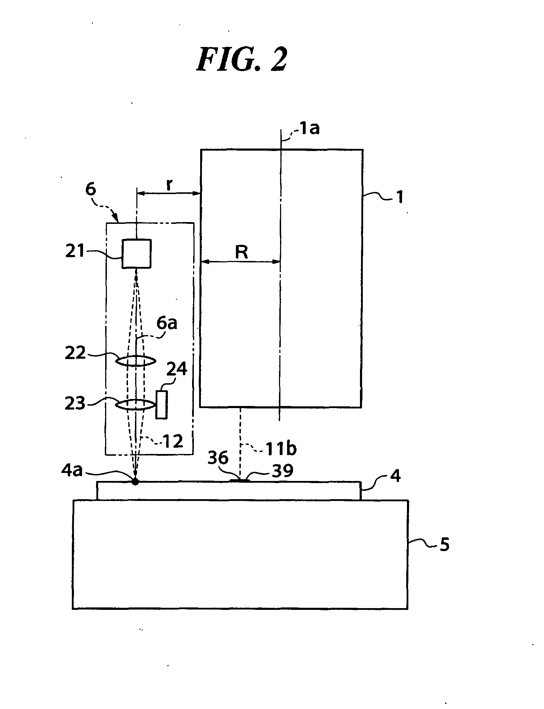

Fig. 2 is a diagram for representing a concrete structural example of the mark position detecting system.

The wafer mark position detecting system 6 of this concrete example is like an optical microscope. The wafer stage 5 is positioned in such a manner that the wafer mark 4a is located just under an optical axis 6a (detection center) of the mark position detecting system 6, an enlarged image of the mark 4a is detected by a detector 21 such as a CCD, and then, a position of the mark is detected by executing an image processing operation. The wafer mark position detecting system 6 of this example is arranged by a light source (not shown), an illuminating optical system (not shown), detecting optical systems 22/23, and the detector 21 such as the CCD. The light source produces light which can be hardly lithographically sensed by a resist. The illuminating optical system illuminates the light emitted from the light source to the mark. The detecting optical systems 22 and 23 project an image of the mark in an enlarge manner onto the detector. Since the numerical aperture of the detecting optical system is increased so as to acquire a mark image with high contrast, the position of the mark can be detected in high precision. While a position adjusting system 24 is provided with the mark position detecting system 6, this system 24 will be explained later.

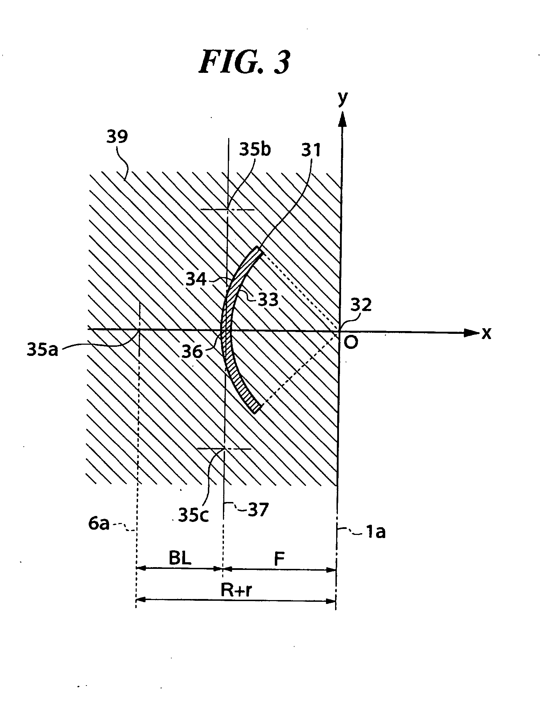

Referring now to Fig. 3, a description will be made of a positional relationship between the exposure image field and the detection center of the wafer mark position detecting system in the x-ray projection exposure apparatus according to the present invention.

This drawing indicates such a case that the exposure image field 31 has a ring shape, namely a plane (image plane of x-ray projecting optical system) involving the exposure image field 31, as viewed from an upper side. In this example, the exposure image field 31 is equal to such an area which is sandwiched by two arcs 33 and 34. These two arcs 33 and 34 have a certain radius and an open angle, while a cross point 32 between the optical axis of the x-ray projecting optical system and the image plane of this x-ray projecting optical system is used as a center. As previously described, since a wide image field can be hardly set in the vicinity of the center axis of the optical system in the reflection type optical system, the exposure image field owns such an arc shape (ring shape).

The detection center of the wafer mark position detecting system 6 is arranged, as shown in Fig. 2, at a position separated from the center axis 1a of the x-ray projecting optical system 1 by a predetermined distance, because of restrictions caused by mechanical interference between the mark position detecting system 6 and the x-ray projecting optical system 1. Normally, since the mark position detecting system 6 is mounted on the side wall of the lens-barrel of the projecting optical system 1, a distance between the center axis 6a (namely, detection center) of the mark position detecting system 6 and the center axis 1a of the X-ray projecting optical system 1 becomes nearly equal to such a value obtained by adding a radium "r" (for example, 50 mm) of the mark position detecting system 6 (lens-barrel) to a radius "R" (For instance, 300 mm) of the X-ray projecting optical system 1( lens-barrel).

As indicated in Fig. 3, in accordance with the present invention, in the case that while the cross point 32 (center of projecting optical system) between the center axis of the x-ray projecting optical system and the image plane thereof is set as an origin, an x-y coordinate system is determined in such a manner that the center 36 of the exposure image field 31 is located at a position defined by x < 0 on the x axis, the detection center 35a of the wafer mark position detecting system 6 is arranged within an area of x ≤ 0 (namely, area 39 shown in this drawing by inclined line).

In other words, while a line which connects the origin 32 corresponding to the center axis of the X-ray projecting optical system with the center 36 of the exposure image field 31 is set as the x axis, and the x coordinate is set in such a manner that the center 36 of the exposure image field 31 becomes minus, as viewed from the origin 32. Then, similarly, the mark detection center 35a is also positioned on the minus side (involving zero). When this fact is expressed by another expression, it may be expressed that the detection center 35a of the mark position detecting system is located on the side of the exposure image field 31 with respect to the center axis 1a of the projecting optical system. It should also be noted that this x axis is normally made coincident with such an axis along which the wafer stage is fed for scanning.

Since the detection center 35 is arranged in the above-described area, the base line BL (namely, distance between detection center 35 and exposure image field center 36) can be made smaller than that obtained in the case that this detection center 35 is arranged at another place. As a result, the drive distance of the wafer stage defined from the alignment position up to the exposure position can be shortened, so that the stability of the base line can be improved. More specifically, when the detection center is arranged at the point 35a on the x axis, the stability of the base line can be improved.

Also, in such a case that the detection center is arranged at the point 35b and the point 35c on a straight line (namely, parallel line of y axis) which passes through the center 36 of the exposure image field and is intersected with the x axis at a right angle, the coordinate system can be grasped in a simple manner, so that the stability of the base line can be improved.

It should also be noted that the mark position detecting system cannot be located at such a position where this mark position detecting system may interfere with the optical lens-barrel of the projecting optical system even within the above-described hatched area 39, but this mark position detecting system is actually located at a position separated from the origin 32 by a distance longer than the distance R shown in Fig. 2 + "r" (namely, radius of projecting optical system lens-barrel + radius of mark position detecting system). The shortest length of the base line BL is such a case that the detection center 35a is located on the x axis of Fig. 3. A dimension of the base line BL in this case becomes such a value obtained by subtracting a distance "F" between the origin 32 and the center 36 of the exposure image field from the above-described distance "R + r."

While visible light, infrared light, or ultraviolet light is irradiated onto the above-described mark, the above-explained mark position detecting system may preferably detect reflection light, scattering light, or diffraction light of these visible light, infrared light, ultraviolet light. Since the optical detection method is employed, high detection precision can be obtained. In particular, when a wavelength width of detection light is made wide, an interference effect of light within a resist is decreased, so that detection precision may be improved.

Also, in such a case that the mark position detecting system is arranged by the optical apparatus, and a portion of this optical system is arranged within vacuum corresponding to the exposure environment, it is preferable to design a difference between a refractive index of an environment medium and a refractive index of an optical element as a refractive index difference between vacuum and glass. As a result, an optical system having high resolution may be manufactured, and also, the mark position detecting precision may also be improved.

On the other hand, when the mark position detecting system is adjusted, if this mark position detecting system can be adjusted within the atmosphere, then the adjustment can be easily carried out. At this time, such an optical system which has been designed in such a manner that aberration thereof within vacuum becomes optimum cannot always obtain the same aberration characteristics within the atmosphere. In particular, there are many possibilities that the focal distance is largely changed. Therefore, a correcting mechanism of a focal position may be preferably provided within the mark position detecting system. Since this correction function is provided, the mark position can be detected even in the atmosphere, so that the mark position detecting system can be adjusted in an easy manner.

The above-described correcting mechanism may be realized in such a way that, for instance, a portion of lenses which constitute the optical system is moved along the optical axial direction. All of the optical systems of the mark position detecting system may be arranged within the vacuum chamber. Alternatively, while a portion of the optical systems may be arranged within the vacuum chamber, the remaining portion of the optical systems may be arranged outside the vacuum chamber. The first-mentioned arranging mode is preferable. That is, since the positional adjustment of the lenses and the like should be carried out within vacuum, as indicated in Fig. 2, when an actuator 24 such as a motor which may be driven within vacuum is arranged, the lenses provided within the vacuum may be remote-controlled. In the last-mentioned arranging mode, the adjusting mechanism may be arranged within vacuum similar to the first-mentioned arranging mode. Alternatively, this adjusting mechanism may be preferably arranged outside the vacuum chamber. In this last-mentioned arranging mode, the adjusting mechanism may be made in low cost.

The mark position detecting system is not always limited to the optical detecting system. Alternatively, while electron beams, x-rays, or particle beams are irradiated onto a mark, such a mark position detecting system may be employed which may detect electron beams, x-rays, or particle beams, which are reflected, scattered, or excited from the mask, or which pass through the mask. As to the x-ray projection exposure apparatus, since the exposure environment is vacuum, this x-ray projection exposure apparatus may detect any of the above-described electron beams, x-rays, and particle beams, which can be easily absorbed by air and also can be hardly detected by the conventional exposure apparatus. While such a feature is utilized, the high detection precision can be achieved by employing the means different from the conventional exposure apparatus.

Although the present invention will be explained in more concrete manners, the present invention is not limited only to these concrete examples.

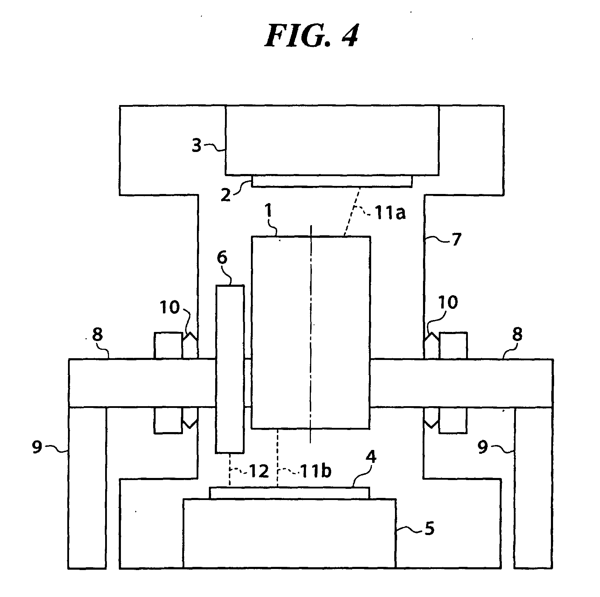

Fig. 4 shows an x-ray projection exposure apparatus corresponding to a first embodiment mode of the present invention.

This apparatus is mainly arranged by an x-ray light source (not shown), an x-ray illuminating optical system (not shown), an x-ray projecting optical system 1, a mask stage 3 for holding a mask 2, a wafer stage 5 for holding a wafer 4, a wafer mark position detecting system 6, a mask mark position detecting system (not shown), a vacuum chamber 7, a base member 8 for supporting a lens-barrel, and also, a vibration eliminating base 9 for supporting the base member 8.

In this apparatus, a laser plasma x-ray source is employed as the x-ray light source, and x-rays generated from this laser plasma x-ray source are irradiated via the x-ray illuminating optical system onto the mask 2. At this time, while an exposure wavelength is selected to be, for example, 13.5 nm, a reflection type mask is employed as the mask 2. X-rays 11a which are reflected from the mask 2 pass through the x-ray projecting optical system 1 and then are reached onto the wafer 4, and then a mask pattern is transferred and demagnified onto the wafer 4.

While the x-ray projecting optical system 1 is constituted by 6 reflection mirrors and also a magnification of the x-ray projecting optical system 1 is selected to be 1/4, this x-ray projecting optical system 1 owns a ring-shaped exposure image field having a width of 2 mm and also a length of 30 mm. These six reflection mirrors are supported within the lens-barrel. Since the lens-barrel is made of an Invar, thermal deformation thereof can hardly occur.

As to the reflection mirrors, the shapes of the reflection planes are aspherical planes, and Mo/Si multi-layer films are coated on the aspherical surfaces thereof in order to improve reflection indexes as to the x-rays. Precisely speaking, this Mo layer is formed in such a manner that the Mo layers and the Ru layers are alternately stacked, and such an Mo layer is employed in which internal stress of the multi-layer film is lower than, or equal to 30 MPa.

While an exposing operation is carried out, the mask 2 is scanned by the mask stage 3 and also the wafer 4 is scanned by the wafer stage 5. The scanning speed of the wafer is continuously synchronized with 1/4 of the scanning speed of the mask. As a result, the pattern formed on the mask may be transferred onto the wafer in such a manner that this pattern is demagnified by 1/4.

As the wafer mark position detecting system 6, the above-described specific optical microscope may be employed. An enlarged image of the mark formed on the wafer is imaged by a CCD, and then, the imaged mark is processed by the image processing operation so as to detect a position of the wafer.

As indicated in Fig. 3, the detection center of the wafer mark position detecting system 6 is arranged on the position of the point 35a on the x axis. In other words, the wafer mark position detecting system is arranged in such a manner that an image of the mark at this position can be observed. In this case, the'wafer mark position detecting system 6 is arranged in such a manner that the base line (namely, BL of Fig. 3) equal to an interval between the center 36 of the exposure image field and the detection center 35a can become minimum as short as possible.

The wafer mark position detecting system 6'is fixed on the base member 8. The base member 8 is arranged on the vibration eliminating base 9 in order that vibrations can be hardly transferred to both the x-ray projecting optical system and the wafer mark position detecting system. In order not to transfer vibrations produced from the mask stage 3, the wafer stage 5, and the like to the base member, such a construction is made. That is, a shock absorbing member 10 such as bellows is sandwiched between the vacuum chamber 7 and the base member 8. Since the above-described structure is employed, the positional relationship between the x-ray projecting optical system 1 and the wafer mark position detecting system 6 may be kept substantially constant.

With employment of the above-described system, the position of the mark of the wafer may be detected lower than, or equal to 10 nm in high precision. Also, the stability lower than, or equal to 10 nm as to the base line may be obtained. The exposure apparatus according to the present invention may overlay the exposing pattern on the circuit pattern formed on the wafer surface in high accuracy based upon this detection result, and then, exposes the overlay patterns, so that a resist pattern having a minimum size of 0.07 µm can be obtained over an entire area of one semiconductor chip on the wafer, corresponding to a desirable area, with having a desirable shape. Furthermore, the exposure apparatus can manufacture devices in a high yield and a high throughput.

A description will now be made of such an example that a wafer on which a resist has been coated is exposed by employing the x-ray projection exposure apparatus of the above-described embodiment mode.

When the wafer is exposed, while a plurality of marks formed on the surface of the wafer are previously detected by the mark position detecting system, an interval of these marks is measured. Then, a magnification correction amount is calculated from a difference between the measurement value and the designated value, while this magnification correction amount is optimum with respect to the exposing operation. Then, both the mask and the wafer are moved respectively along the optical axis direction of the x-ray projecting optical system so as to correct the projection magnification.

Next, a base line corresponding to a distance between a center of an exposure image field and a detection center is measured.

Furthermore, both the mark formed on the wafer surface and the mark formed on the mask surface are detected by the wafer mark position detecting system and the mask mark position detecting system, respectively. Then, both the wafer stage and the mask stage are driven so as to adjust the wafer position in such a manner that a projected pattern may be formed on the previously-formed circuit pattern in such a precision lower than, or equal to the desirable overlay accuracy based upon the value of the base line which has already been measured.

Since the above-described exposure method is carried out, a resist pattern having a minimum size of 0.07 µm can be obtained over an entire area of one semiconductor chip on the wafer, corresponding to a desirable area, with having a desirable shape. At this time, the resulting overlay accuracy lower than, or equal to 10 nm can be expected.

While the x-ray projection exposure apparatus of the above-described example is employed, a method for manufacturing a semiconductor device by executing the exposure method of the above-described example will now be described.

It is so assumed that the semiconductor device is, for example, a 16-GB (giga bytes) DRAM. While circuits of 22 layers are formed in this device, 15 layers among these layers are exposed by the x-ray projection exposure apparatus according to the present invention. Since a minimum pattern size is larger than, or equal to 0.15 µm, the remaining 7 layers are exposed by using an excimer laser exposure apparatus. While these exposure operations are carried out, such process operations as resist coating, doping, annealing, etching, and depositions are carried out, and then, a device circuit is manufactured. Then, finally, the silicon wafer is cut to be divided into chip-shaped silicon wafers, and each of these chips is enveloped into a package made of ceramics.

The semiconductor device which has been manufactured in the above-described manner owns such a large capacity of 16 GB, and also, may represent a desirable electric characteristic.

### INDUSTRIAL APPLICABILITY

As previously described, in accordance with the x-ray projection exposure apparatus of the present invention, the base line can be kept stable. As a result, with respect also to the process wafer having the large deformation amount, the exposing operation can be carried out in the high overlay accuracy as well as with the high throughput.

## Claims

1. An X-ray projection exposure apparatus comprising:
an X-ray source;
an X-ray illuminating optical system for irradiating X-rays generated from the X-ray source onto a mask having a certain pattern;
a mask stage for holding the mask;
an X-ray projecting optical system for receiving X-rays derived from the mask to project an image of the pattern onto a wafer on which a resist has been coated;
a wafer stage for holding the wafer; and
a mark position detecting system for detecting a position of a mark which is formed on either the wafer or the wafer stage; wherein:
an exposure image field of said X-ray projecting optical system is located at a position separated from a center axis of the X-ray projecting optical system; and
a detection center of said mark position detecting system is located on the side of said exposure image field with respect to the center axis of said X-ray projecting optical system.

2. An X-ray projection exposure apparatus comprising:
an X-ray source;
an X-ray illuminating optical system for irradiating X-rays generated from the X-ray source onto a mask having a certain pattern;
a mask stage for holding the mask;
an X-ray projecting optical system for receiving X-rays derived from the mask to project an image of the pattern onto a wafer on which a resist has been coated;
a wafer stage for holding the wafer; and
a mark position detecting system for detecting a position of a mark which is formed on either the wafer or the wafer stage; wherein:
an exposure image field of said X-ray projecting optical system is located at a position separated from a center axis of the X-ray projecting optical system; and
in such a case that while a cross point between the center axis of said X-ray projecting optical system and an image plane of said X-ray projecting optical system is set as an origin on the image plane of said X-ray projecting optical system, an x-y coordinate system is defined in such a manner that a center of the exposure image field is located at a position of x < 0 on an x axis, a detection center of the mark position detecting system is located within an area of x ≤ 0.

3. An X-ray projection exposure apparatus as claimed in claim 2 wherein:
said detection center is arranged either on said x axis or on a straight line which passes through the center of the exposure image field of said X-ray projecting optical system and is intersected with the x axis at a right angle.

4. An X-ray projection exposure apparatus as claimed in claim 1, or claim 2 wherein:
said mark position detecting system irradiates visible light, infrared light, or ultraviolet light onto said mark, and detects reflection light, scattering light, or diffraction light of said visible light, said infrared light, or said ultraviolet light.

5. An X-ray projection exposure apparatus as claimed in claim 1, or claim 2 wherein:
said mark position detecting system is arranged by an optical system, and the optical system owns a function for correcting a change in focal positions, which is caused by a refractive index change of a medium of an optical path.

6. An X-ray projection exposure method wherein:
X-rays generated from an X-ray source are irradiated onto a mask having a certain pattern;
the mask is held by a mask stage;
an image of a pattern of the mask is projected onto a wafer on which a resist has been coated;
the wafer is held by a wafer stage;
a position of a mark formed on either the wafer or the wafer stage is detected by employing a mark position detecting system;
an exposure image field of said X-ray projecting optical system is located at a position separated from a center axis of said X-ray projecting optical system;
in such a case that while a cross point between the center axis of said X-ray projecting optical system and an image plane of said X-ray projecting optical system is set as an origin on the image plane of said X-ray projecting optical system, an x-y coordinate system is defined in such a manner that a center of the exposure image field is located at a position of x < 0 on an x axis, a detection center of the mark position detecting system is arranged within an area of x ≤ 0; and
said wafer stage is driven in response to a detection signal of said mark position detecting system so as to form a projection image of a circuit pattern formed on said mask at a desirable position of said wafer.

7. An X-ray projection exposure method as claimed in claim 6 wherein:
a distance between the origin of said x-y coordinate system and the center of the exposure image field of said x-ray projecting optical system is measured, and a drive amount of said wafer stage is determined based upon a measurement value of the distance.

8. A semiconductor device wherein:
said semiconductor device is manufactured by executing an exposing operation in accordance with the X-ray projection exposure method as recited in claim 6, or claim 7.
